Europäisches Patentamt

**European Patent Office**

**Office européen des brevets**

(19)

(11) Numéro de publication: **0 289 791 B1**

## (12) FASCICULE DE BREVET EUROPEEN

(45) Date de publication de fascicule du brevet: **09.09.92** (51) Int. Cl.⁵: **G01R 15/07**

(21) Numéro de dépôt: **88105459.7**

(22) Date de dépôt: **06.04.88**

(54) **Procédé de mise à jour du facteur d'échelle d'un appareil de mesure d'intensité d'un courant électrique alternatif par effet Faraday.**

(30) Priorité: **10.04.87 FR 8705103**

(43) Date de publication de la demande:
**09.11.88 Bulletin 88/45**

(45) Mention de la délivrance du brevet:
**09.09.92 Bulletin 92/37**

(84) Etats contractants désignés:
**BE CH DE ES FR GB IT LI LU NL SE**

(56) Documents cités:
**EP-A- 0 004 321**
**DE-A- 2 042 558**
**FR-A- 2 461 956**
**US-A- 3 769 584**

(73) Titulaire: **GEC ALSTHOM SA**
**38, avenue Kléber**
**F-75116 Paris(FR)**

(72) Inventeur: **Dupraz, Jean-Pierre**
**7 rue de la Paix**
**F-73100 Aix les Bains(FR)**

(74) Mandataire: **Weinmiller, Jürgen et al**
**Lennéstrasse 9 Postfach 24**
**W-8133 Feldafing(DE)**

Rank Xerox (UK) Business Services

## Description

La présente invention se rapporte à la mesure de courants électriques alternatifs et trouve plus particulièrement son application dans le domaine des réseaux de transport et de distribution d'énergie électrique où l'utilisation de l'effet Faraday, qui fait appel à une onde lumineuse, évite la nécessité d'avoir à placer les conducteurs électriques d'un circuit de mesure à proximité immédiate de la haute tension.

L'effet Faraday est un effet magnéto-optique résultant de l'interaction d'une onde électromagnétique et d'un milieu matériel en présence d'un champ magnétique.

Certains milieux matériels présentent, sous l'action d'un champ magnétique de même direction que l'onde électromagnétique, une activité optique se traduisant par une biréfringence circulaire induite, non réciproque, c'est-à-dire par des vitesses de propagation de l'onde dans le milieu, différentes selon qu'elle est à polarisation circulaire dextrogyre ou lévogyre.

La mise en oeuvre de l'effet Faraday pour la mesure de l'intensité d'un courant électrique se fait soit sur une onde lumineuse à polarisation linéaire qui peut être considérée comme la somme de deux ondes lumineuses à polarisation circulaire l'une dextrogyre et l'autre lévogyre et dont on mesure le déphasage de la direction du plan de polarisation par des techniques polarimétrique ou interferométrique, soit sur deux ondes lumineuses contrapropagatives polarisées circulairement de la même manière lévogyre ou dextrogyre dont on mesure l'écart de phase par une technique interférométrique dite de Sagnac.

Dans les deux cas d'une onde lumineuse à polarisation linéaire ou de deux ondes lumineuses contraprogatives à polarisation circulaire, l'angle de déphasage $\Delta \phi$ dû à l'effet Faraday est proportionnel à l'intensité instantanée I du courant à mesurer dans le rapport d'un coefficient k1 appelé par la suite facteur d'efficacité de l'effet Faraday :

$$\Delta \phi = k1\,I = a\,V\,N\,I$$

a valant 1 pour une onde à polarisation linéaire et 2 pour les ondes contrapropagatives à polarisation circulaire, V étant la constante de Verdet et N le nombre de tours parcourus par les ondes lumineuses autour du conducteur traversé par le courant à mesurer.

Les techniques interférométriques qui font appel au battement de deux ondes lumineuses permettent d'obtenir en sortie d'un photodétecteur un signal qui est une fonction cosinuoïdale de l'intensité instantanée du courant à mesurer puisque celui-ci est proportionnel à la puissance lumineuse P résultant de l'addition des deux ondes lumineuses qui s'exprime par :

$$P = P1 + P2 + 2\sqrt{P1\ P2}\,\cos \Delta \phi$$

(P1, P2 étant les puissances optiques respectives des deux ondes lumineuses) ou encore

$$P = P1 + P2 + 2\sqrt{P1\ P2}\,\cos k1I$$

Ce signal de sortie apparaît sous la forme générale :

$$ko + k2'\cos k1I$$

où ko est une constante et k2′ un coefficient dénommé facteur d'échelle. Il suit une loi de variation à sensibilité nulle dans la plage des petits courants qui est, en pratique, celle où l'on cherche un maximum de précision. Pour éviter cet inconvénient, on a tenté de modifier les conditions de l'interférométrie pour obtenir un signal de sortie à loi de variation sinuoïdale.

Pour davantage de détails, on peut se reporter à la demande de brevets français FR-A-2 461 956 qui décrit des appareils de mesure d'intensité d'un courant électrique par effet Faraday mis en oeuvre au sein d'un interféromètre de Sagnac ayant un signal de sortie présentant une composante dont l'amplitude est une fonction sinusoïdale de l'intensité instantanée du courant à mesurer. Cette propriété du signal de sortie est obtenue par modulation de l'angle de déphasage entre les deux ondes lumineuses contrapropagatives parcourant la boucle de l'interféromètre en provoquant au sein de cette dernière des phénomènes de biréfringence soit non réciproques par modulation de l'intensité d'un courant parcourant un enroulement auxiliaire, soit réciproques mais pulsés à la demi-fréquence de résonance de la boucle de l'interféromètre, dite fréquence propre de l'interféromètre, de manière à provoquer des écarts de phase instantanés égaux mais de signes opposés sur les deux ondes contrapropagatives, par effet élasto-optique ou élasto-acoustique.

L'ajout de ces phénomènes de biréfringence réciproques ou non a pour effet de transformer l'expression de la puissance lumineuse P des deux ondes lumineuses issues de l'interféromètre, de la manière suivante :

$$P = P1 + P2 + \sqrt{P1\ P2}\ \cos\ [\Delta \phi + 2 \alpha \cos (2n\ f\ b + B)]$$

Cette puissance lumineuse P possède un spectre de fréquence riche en composantes avec notamment :
- une composante continue,
- une composante à la fréquence f de modulation proportionnelle à $\sin \Delta \phi$ ayant un maximum de variation dans la plage des petits courants,
- une composante au double de la fréquence f de modulation proportionnelle à $\cos \Delta \phi$ qui s'annule avec le courant à mesurer.

La composante à la fréquence f du signal de sortie de l'interféromètre est séparée des autres et démodulée de manière synchrone pour délivrer un signal de la forme :

k2 sin (k1 I)

k2 étant un nouveau facteur d'échelle. Ce facteur d'échelle k2 a, comme le précédent k2', l'inconvénient d'être sensible aux dérives des divers éléments de la chaîne de mesure et notamment aux variations de la puissance lumineuse émise par la source lumineuse délivrant le faisceau dont sont issues les deux ondes contrapropagatives parcourant la boucle de l'interféromètre et d'entraîner une imprécision importante dans la mesure.

Pour résoudre cette difficulté, il est proposé dans le brevet français précité d'utiliser une méthode de zéro en soumettant la boucle de l'interféromètre à un champ magnétique de référence engendré par une bobine auxiliaire parcourue par un courant de référence d'intensité réglable de manière à compenser le déphasage $\Delta \phi$ induit par effet Faraday par le courant à mesurer.

Cette méthode de zéro a pour inconvénient d'être très difficile à mettre en oeuvre dans le cadre des réducteurs de mesure d'intensité à haute tension en raison de la complexité de réalisation de la bobine auxiliaire. En effet, le produit du nombre des spires de fibre optique par le nombre des spires de conducteur électrique de cette bobine auxiliaire est proportionnel au rapport de réduction devant exister entre l'intensité du courant de référence et celle du courant à mesurer qui est de l'ordre de 100.000.

La présente invention a pour but de remédier à l'imprécision de la mesure due à la dérive du facteur d'échelle sans employer une méthode de zéro afin de permettre la réalisation de réducteur de mesure d'intensité haute tension à un prix qui ne soit pas prohibitif.

Elle a pour objet un procédé de mise à jour du facteur d'échelle k2 d'un appareil de mesure d'intensité d'un courant électrique alternatif I1 sin wt par effet Faraday mis en oeuvre au sein d'un interféromètre délivrant en sortie un faisceau lumineux ayant une puissance optique avec une composante de son spectre de fréquence qui est proportionnelle dans le rapport dudit facteur d'échelle k2 au sinus ou au cosinus de l'écart de phase engendré par l'effet Faraday sur les ondes lumineuses parcourant l'interféromètre, ledit écart de phase étant lui-même proportionnel à l'intensité instantanée du courant à mesurer dans le rapport d'un facteur dit d'efficacité de l'effet Faraday k1, et qui est extraite par un photodétecteur et une électronique associée pour constituer un signal de sortie s(t) = k2 sin(k1 I1 sin wt) de l'interféromètre, ce procédé mis en oeuvre périodiquement consiste à :
- déterminer l'intensité crête I1 du courant alternatif à mesurer à partir du signal de sortie s(t) de l'interféromètre, de la valeur du coefficient k1 d'efficacité de l'effet Faraday pour le courant à mesurer et de la valeur disponible du facteur d'échelle k2,
- provoquer deux perturbations successives, d'amplitudes différentes, par ajout à l'effet Faraday du au courant alternatif à mesurer I1 sin wt d'un effet Faraday auxiliaire engendré par un courant continu de test prenant successivement deux valeurs distinctes I21 et I22 différentes de zéro avec des facteurs d'efficacité d'effet Faraday k3, k4
- mémoriser les composantes continues so1 et so2 du signal de sortie s(t) de l'interféromètre en réponse aux deux perturbations précédentes et,
- adopter comme nouvelle valeur du facteur d'échelle celle de l'expression :

$$\dfrac{so1 \quad - \quad so2}{J_o \ (k1.I1) \ \left[\sin k3 \ I21 - \sin k4 \ I22\right]}$$

Jo étant la fonction de Bessel de première espèce d'ordre zéro.

De manière préférentielle, ce procédé n'est mis à jour que dans les périodes où l'intensité du courant alternatif à mesurer est suffisamment faible pour que l'écart angulaire de phase qu'il provoque par effet Faraday k1 I1 ne dépasse pas la dizaine de degrés.

Certains appareils de mesure d'intensité de courant alternatif par effet Faraday comportent un interféromètre à ondes lumineuses modulées délivrant une sortie un faisceau lumineux à puissance optique présentant un spectre de modulation à raies dont une, à une fréquence supérieure à celle du courant alternatif à mesurer, possède une amplitude proportionnelle, dans le rapport d'un coefficient d'échelle, au sinus de l'écart de phase dû à l'effet Faraday et est extraite en sortie d'un photodétecteur par une électronique associée pour constituer le signal de sortie de l'interféromètre. Pour ces appareils, il est avantageux, dans le procédé de mise à jour du facteur d'échelle et plus généralement lors de toute détermination de l'intensité du courant à mesurer, de supprimer périodiquement la modulation pour faire disparaître la raie à l'origine du signal de sortie de l'interféromètre et utiliser la valeur résiduelle de ce signal de sortie comme terme correctif de la dérive du zéro du signal de sortie de l'interféromètre.

D'autres avantages et caractéristiques de l'invention resortiront de la description ci-après d'un appareil de mesure de courant le mettant en oeuvre.

Cette description sera faite en regard du dessin dans lequel :

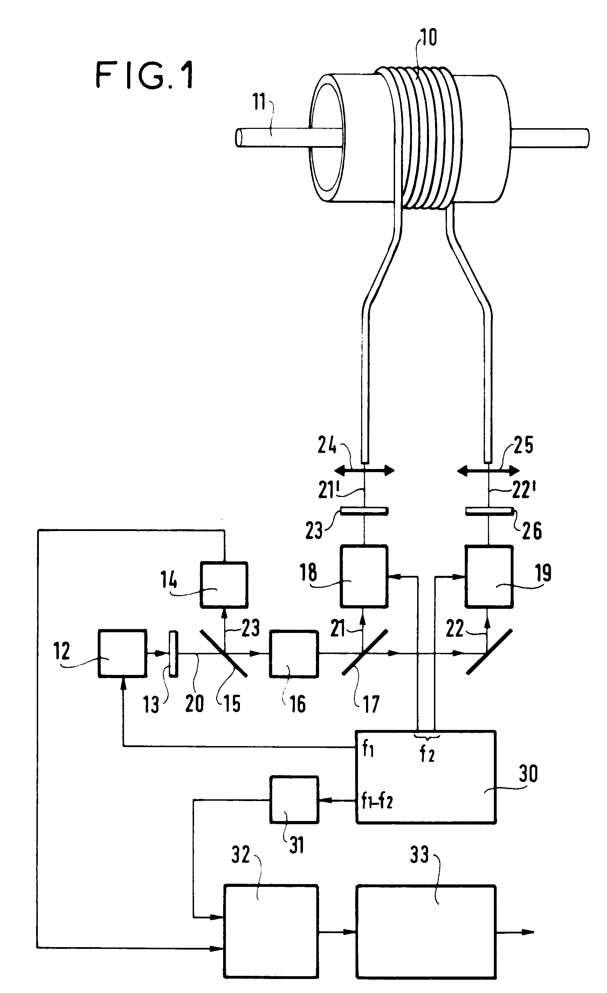

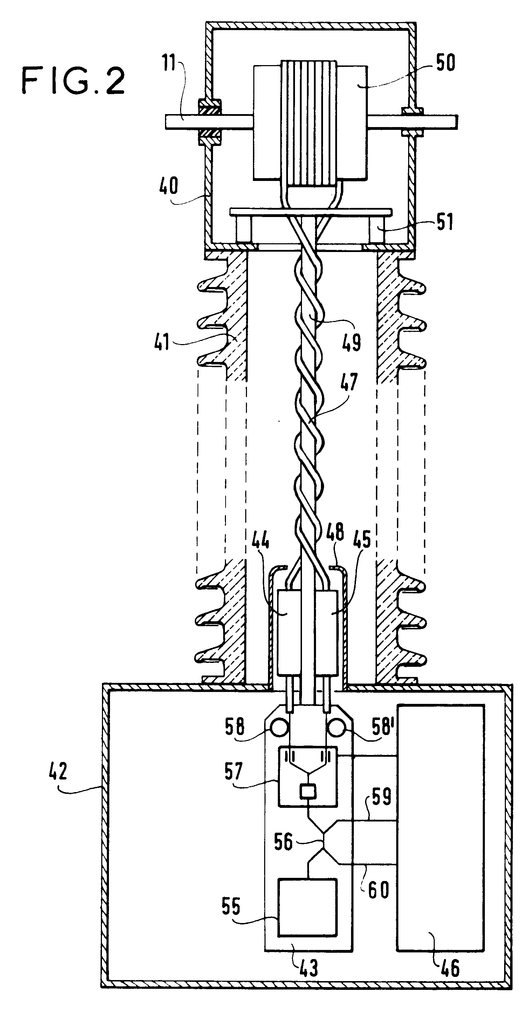

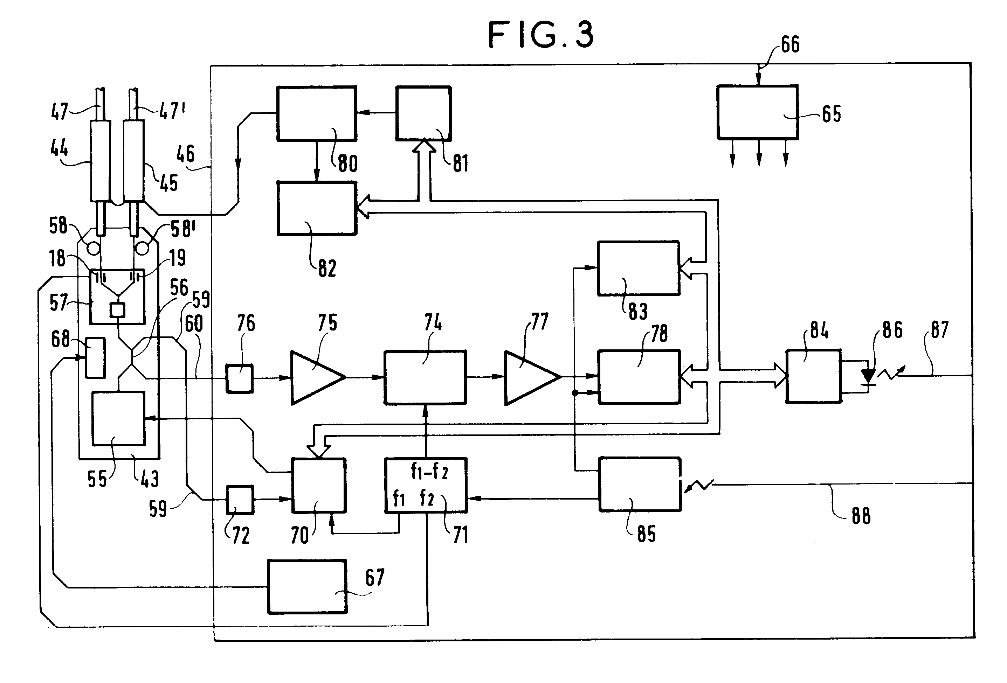

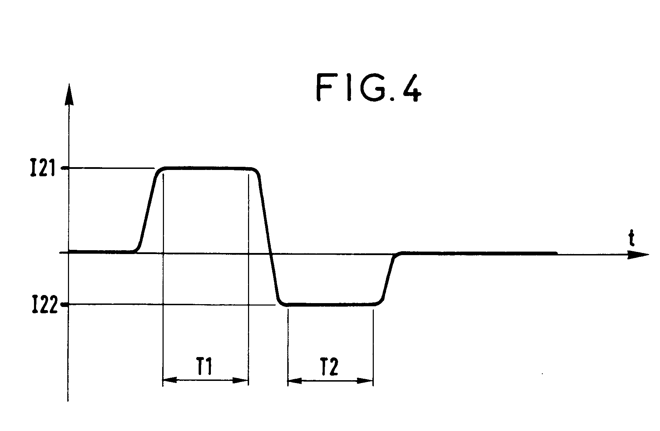

- une figure 1 représente le schéma de principe d'un appareil de mesure d'intensité d'un courant alternatif mettant en oeuvre le procédé selon l'invention,
- une figure 2 représente une disposition pratique des éléments de l'appareil de mesure de la figure 1,
- une figure 3 détaille la partie électronique de traitement de signal de l'appareil de mesure de la figure 1,
- et une figure 4 est un diagramme illustrant le fontionnement d'une partie d'autocalibration de la partie électronique de traitement de signal représentée à la figure 3.

L'appareil qui va être décrit est destiné à la mesure d'intensité de courants électriques alternatifs dans un appareillage haute tension.

Son schéma de principe est représenté à la figure 1. Une fibre optique 10, monomode à haute biréfringence circulaire entoure une ou plusieurs fois un conducteur électrique 11 traversé par un courant alternatif I1 sin wt dont on veut mesurer l'intensité. Une source de lumière cohérente 12 émet un faisceau lumineux 20 à polarisation linéaire dont la polarisation peut être ajustée angulairement par un dispositif demi-onde 13. Ce faisceau à polarisation linéaire traverse une lame séparatrice 15, puis un polariseur 16, et se sépare sur une lame séparatrice en deux ondes lumineuses 21 et 22 à polarisation linéaire.

L'onde lumineuse 21 traverse un modulateur de phase 18, puis une lame quart d'onde 23, donnant ainsi naissance à une onde lumineuse 21' à polarisation circulaire qui est injectée dans la fibre optique 10 au moyen d'une optique 24, et qui, après propagation autour du conducteur 11, émerge de la fibre optique 10 par une autre optique 25 et traverse une lame quart d'onde 26 disposée de façon à lui redonner une polarisation linéaire avec un plan de polarisation identique à celui des faisceaux 21 et 22 en l'absence d'effet Faraday. En sortie de la lame quart d'onde 26, elle traverse un modulateur de phase 19 commandé en opposition de phase relativement au modulateur 18, puis la lame séparatrice 17, le polariseur 16, se réflèchit sur la lame séparatrice 15 et frappe la surface sensible du photodétecteur 14.

L'onde lumineuse 22 effectue le même trajet, mais en sens inverse, de sorte qu'elle traverse successivement le modulateur 29, la lame quart d'onde 26, la fibre 10, la lame quart d'onde 23, le modulateur 18, se réfléchit sur la lame séparatrice 17, traverse le polariseur 16, et enfin, après réflexion sur la lame séparatrice 15, frappe le photodétecteur 14, au niveau duquel elle interfère avec l'onde lumineuse précédente.

Le faisceau unique 20 a donc donné naissance à deux ondes polarisées circulairement, toutes deux dextrogyres ou toutes deux lévogyres, qui ont fait une ou plusieurs fois le tour de conducteur 1, mais en sens inverses, dans le milieu matériel que constitue la fibre optique 10.

La mise en oeuvre de la fibre optique 10 est telle qu'elle lui confère d'une part une très forte biréfringence circulaire, et d'autre part, une insensibilisation aux vibrations mécaniques. Ceci est obtenu en torsadant la fibre sur elle-même, et en l'enrobant d'un gel silicone. Les rayons de courbure de la fibre sont aussi grands que possible, pour minimiser les effets des biréfringences linéaires associées aux contraintes

EP 0 289 791 B1

de courbure. L'ensemble des composants optiques autres que la fibre optique 10 est localisé sur une platine optique compacte placée en dehors du potentiel élevé du courant à mesurer. La fibre optique 10 constitue un milieu de propagation continu, sans raccord ni soudure, propre à assurer une bonne conservation de polarisation circulaire à la fois autour du conducteur électrique dont l'intensité de courant est à mesurer et sur le trajet du conducteur à la platine optique.

Le passage du courant I1 sin wt dans le conducteur 11 engendre une biréfringence non réciproque dans la fibre optique 10, de telle sorte que les ondes lumineuses contrapropagatives subissent un déphasage relatif $\Delta \phi$ proportionnel à son intensité :

$$\Delta \phi = k1 \; I1 \; \sin wt$$

Ces deux faisceaux interfèrent au niveau du détecteur optique 14 et délivrent une puissance optique maximum en l'absence de courant et de modulation car ils suivent alors des chemins optiques identiques.

Les modulateurs de phase 18, 19 sont commandés en opposition par une tension variant sinuoïdalement à une fréquence f2 choisie le plus proche possible de la fréquence propre de l'interféromètre sans toute fois la dépasser.

De cette manière, les modulateurs 18 et 19 engendrent à tout instant sur les deux ondes contrapropagatives, des déphasages égaux mais de signes opposés et d'amplitude périodique, qui s'ajoutent au déphasage $\Delta \phi$ de l'effet Faraday. Ils modifient l'expression de la puissance optique P du faisceau résultant de la manière suivante :

$$P = P1 + P2 + 2\sqrt{P1 \; P2} \cos [\Delta \phi + \alpha \cos (2\pi f2t + \beta)] \qquad (2)$$

$\alpha$ étant un coefficient de taux de modulation de phase.

Simultanément, la puissance optique de la source de lumière cohérente 12 est modulée en amplitude, sinuoïdalement, à une fréquence f1 légèrement supérieure à la fréquence f2 donnant aux puissances P1 et P2 des faisceaux lumineux entrant dans l'interféromètre une loi de variation de la forme

$$P1 = Po1 \; (1 + m \sin 2\pi f1 \; t)$$
$$P2 = Po2 \; (1 + m \sin 2\pi f1 \; t)$$

Po1, Po2 étant des constantes et m un taux de modulation d'amplitude de sorte que la puissance optique P du faisceau résultant en sortie de l'interféromètre répond à la relation :

$$P = (1 + m \sin 2\pi f1t)[Po1 + Po2 + 2\sqrt{Po1 \; Po2} \cos (\Delta \phi + \alpha \sin (2\pi f2t + \beta)] \qquad (3)$$

L'analyse mathématique de cette relation au moyen des fonctions de Bessel montre que la puissance optique P du faisceau issu de l'interféromètre possède un spectre de fréquence très riche en harmonique avec une raie à la fréquence f1-f2 qui peut être isolée par filtrage et démodulation et dont la puissance P′ est proportionnelle au sinus du déphasage $\Delta \phi$ dû à l'effet Faraday :

$$P' = \tfrac{1}{2} m \; Po \; J1 \; (\alpha) \sin \Delta \phi \sin [2 \pi (f1 - f2) \; t + \phi] \qquad (4)$$

(J1 étant une fonction de Bessel de première espèce d'ordre 1).

Un générateur synthétiseur de fréquence 30 élabore un signal de commande de modulation de l'amplitude de la puissance d'émission de la source lumineuse 12 à la fréquence f1, des signaux de commande des modulateurs de phase 18, 19 à la fréquence f2 et un signal d'horloge à la fréquence f1 - f2 pour un circuit de détection synchrone 32.

Le signal de sortie du détecteur optique 14 est injecté, après amplification et filtrage, à l'entrée du circuit de détection synchrone 32 suivi d'un circuit d'amplification et de filtrage 33 qui délivre en sortie un signal s (t) permettant de connaître l'intensité du courant à mesurer avec un maximum de sensibilité dans la plage des petits courants car son amplitude est proportionnelle au sinus de l'angle de déphasage engendré par effet Faraday et par conséquent au sinus de l'intensité de courant I1 à mesurer

$$s \; (t) = k2 \sin (k1 \; I1 \; \sin w \; t) \qquad (5)$$

5

$$I1 \sin wt = \frac{1}{k1} \text{ Arc } \sin\left[\frac{s(t)}{k2}\right] (6)$$

Cette technique de double modulation permet d'effectuer la démodulation synchrone à une fréquence f1 - f2 beaucoup plus basse que la fréquence propre de l'interféromètre ce qui a deux avantages : permettre de réduire au minimum la longueur de fibre optique monomode 10 dans la boucle de l'interféromètre car celle-ci est sensible par nature aux perturbations mécaniques à l'origine de couplages de modes de propagation, et simplifier la réalisation de la détection.

Cela permet également une standardisation de la partie délicate du traitement du signal placée en aval du circuit de détection synchrone 32 en maintenant la fréquence intermédiaire fo constante même si la longueur de la fibre optique varie d'un appareil à l'autre entraînant une variation de la fréquence propre de l'interféromètre car cette variation, qui entraîne une variation de la fréquence f2 de modulation de phase, peut être compensée par une variation correspondante de la fréquence f1 de la modulation d'amplitude.

La figure 2 représente une disposition préférentielle des éléments du dispositif de mesure de courant pour une application à des lignes de courants électriques alternatifs à haute tension. On distingue sur cette figure 2 une tête de mesure 40 portée par une enveloppe isolante 41 et un soubassement 42.

La tête de mesure 40 et l'enveloppe isolante 41 délimitent un volume intérieur creux conditionné de façon à assurer le fort isolement électrique nécessaire aux appareillages haute tension par exemple, grâce à un remplissage avec un gaz tel que de l'hexafluorure de soufre SF 6, la colonne isolante 41 pouvant être en porcelaine ou en un matériau synthétique.

Le soubassement 42 de la colonne isolante 41 contient une platine optique 43, deux enroulements électriques auxiliaires 44, 45 dont le rôle sera précisé ultérieurement et une platine électronique 46.

La colonne 41 contient essentiellement un mat isolant central 49 autour duquel s'enroule en hélice un câble isolant 47 de conditionnement de fibre optique aboutissant par ses deux extrémités dans le soubassement 42 et une cloison métallique pare-éffluve 48 assurant le blindage électrostatique des enroulements électriques auxiliaires 44, 45.

La tête de mesure 40 renferme un mandrin 50 qui entoure un conducteur électrique 11 traversé par un courant électrique alternatif à mesurer et sur lequel est bobinée la partie médiane du câble isolant 47 de conditionnement de fibre optique. Ce mandrin 50 est fixé au boîtier de la tête de mesure par l'intermédiaire d'un dispositif amortisseur 51 assurant le filtrage mécanique des vibrations.

Le câble isolant 47 renferme une fibre optique monomode à très faible biréfringence intrinséque qui est torsadée sur elle-même pour acquérir une très forte biréfringence circulaire et maintenue en l'état par un enrobage en gel de silicone constituant un excellent diélectrique et un bon amortisseur de vibrations mécaniques. Cette fibre optique qui constitue une boucle d'interféromètre de Sagnac part de la platine 43 disposée dans le soubassement 42, traverse de façon rectiligne l'enroulement électrique auxiliaire 44, s'enroule en hélice autour du mat central 49 de l'enveloppe isolante 41, parvient dans la tête de mesure 40 où elle effectue plusieurs fois le tour du mandrin isolant 50, puis s'enroule à nouveau autour du mat central 49 de l'enveloppe isolante 41 pour revenir au soubassement 42, traverse de façon rectiligne l'enroulement électrique auxiliaire 45 et retourne à la platine optique 43.

La platine optique 43 contient la source lumineuse 55, un coupleur directif monomode à polarisation linéaire 56, un circuit en technologie optique intégrée 57 assurant les fonctions de polariseur, de coupleur directionnel et de modulateur de phase, et enfin deux boucles de fibre optique 58 et 58′ assurant les fonctions de lames quart d'onde. Elle est conditionnée dans une enceinte thermostatée assurant la protection climatique et mécanique, et connectée optiquement à la platine électronique 46 par des fibres optiques multimodes constituant les deux branches de sortie 59 et 60 du coupleur directif, ces liaisons se faisant en fibre multimode car seule l'information puissance lumineuse est utile à leur niveau. Un connecteur électrique permet de relier les commandes électriques du circuit en technologie optique intégrée 57 et de la source lumineuse 55 à la platine électronique 46.

La figure 3 représente une vue détaillée de la platine électronique 46 et de ses connexions avec la platine optique 43.

La platine électronique 46 peut se décomposer en une partie émission engendrant les signaux électriques nécessaires à la double modulation d'amplitude et de phase des deux ondes lumineuses contrapropagatives parcourant l'interféromètre, en une partie réception extrayant du battement des deux ondes lumineuses contrapropagatives à leur sortie de l'interféromètre, un signal proportionnel au sinus de l'intensité du courant à mesurer, en une partie d'autocalibration, en une partie d'exploitation numérique du signal reçu pilotant également la partie d'autocalibration et assurant la transmission de la mesure d'intensité vers l'extérieur du dispositif ainsi qu'une synchronisation éventuelle de cette mesure avec une référence temporelle externe, et en une partie de service comprenant une alimentation électrique 65 de la platine électronique 46 en une régulation thermique de la platine optique 43.

L'alimentation électrique 65 de la platine électronique 46 est de type à découpage. Elle délivre les diverses tensions de polarisation nécessaires et assure une isolation galvanique importante entre la platine électronique 46 et un câble électrique 66 provenant d'une alimentation électrique continue extérieure.

La régulation thermique de la platine optique 43 est assurée par un bloc de régulation 67 couplé à des éléments de mesure de température et de chauffage 68 intégrés à la platine optique 43.

La partie émission comporte un modulateur 70 de la puissance de la source lumineuse 55 et un générateur synthétiseur de fréquence 71. Le modulateur 70, est stabilisé par une boucle de contre-réaction incluant un photodétecteur 72 connecté à la fibre optique 59 constituant la sortie du coupleur directif 56 couplée à la source lumineuse 55. Il est pourvu d'une entrée de porteuse de modulation couplée à une sortie du générateur synthétiseur de fréquence 71 et d'une entrée d'inhibition couplée au processeur de traitement 83 de la partie d'exploitation numérique du signal de la partie réception.

Le générateur synthétiseur de fréquences 71 pilote par une première sortie sur laquelle il délivre une fréquence f1, le modulateur de puissance 70, par une deuxième sortie sur laquelle il délivre une fréquence f2, les modulateurs optiques de phase du circuit en technologie optique intégrée 57 et par une troisième sortie sur laquelle il délivre une fréquence (f1 - f2) un circuit de démodulation synchrone 74 de la partie réception. Il présente une entrée de synchronisation commandée par un circuit d'horloge 85 de la partie d'exploitation numérique du signal reçu.

La partie réception comporte un circuit de démodulation synchrone 74 qui est précédé d'un circuit d'amplification et de filtrage 75 relié à la sortie d'un photodétecteur 76 connecté à la fibre optique 60 constituant la sortie du coupleur directif 56 couplée à l'interféromètre, et suivi d'un autre circuit d'amplification et de filtrage 77 et d'un convertisseur analogique-numérique 78.

Le photodétecteur 76 qui reçoit le battement des deux faisceaux lumineux contrapropagatifs issus de l'interféromètre délivre en sortie un signal proportionnel à la puissance lumineuse reçue qui, comme on l'a vu précédemment (relation 3) s'exprime, en raison des modulations d'amplitude f1 et de phase f2 par la relation :

$$P = (1 + m \sin 2\pi f1 \, t) [Po1 + Po2 + 2 \sqrt{Po1 \; Po2} \cos (\Delta \phi + \alpha \cos (2\pi f2 \, t + \beta)]$$

Ce signal est filtré et amplifié par le circuit 75 pour en tirer une composante à la fréquence f1 - f2 qui est proportionnelle à (relation 4) :

$$P' = \tfrac{1}{2} m \, Po \, J1 \, (\alpha) \sin \Delta \phi \sin [2\pi (f1\text{-}f2) + \phi]$$

et qui, appliquée au circuit de démodulation synchrone 74 puis filtrée et amplifiée dans le circuit 77 donne naissance à un signal s(t) de mesure d'intensité de la forme (relation 5) :

$$s(t) = k2 \sin (k1 \, I1 \sin \omega \, t).$$

Ce signal est échantillonné et numérisé par le convertisseur analogique-numérique 78 qui comporte un échantillonneur-bloqueur commande par la partie d'exploitation numérique du signal reçu et un dispositif de conversion analogique-numérique fontionnant selon les techniques habituelles par exemple par approximations successives.

La partie d'autocalibration comporte un générateur de courant continu 80 débitant dans les enroulements auxiliaires 44, 45, recevant une consigne d'intensité de courant de la partie d'exploitation numérique par l'intermédiaire d'un convertisseur numérique-analogique 81 et délivrant une mesure d'intensité du courant débité à cette même partie d'exploitation numérique par l'intermédiaire d'un convertisseur analogique-numérique 82 qui comporte un échantillonneur-bloqueur commandé par cette dernière.

La partie d'exploitation numérique du signal reçu comporte un processeur de traitement 83, un processeur de communication 84 et un circuit d'horloge 85.

Le processeur de traitement 83 extrait du signal fournit par la partie réception une mesure explicite de l'intensité du courant à mesurer I1 sin wt, gère le fonctionnement de la partie d'autocalibration et assure une correction périodique du facteur d'échelle k2.

Le processeur de communication 84 assure le codage, la sérialisation et la transmission numérique selon un protocole normalisé à haute sécurité, par exemple, de type HDLC, de la mesure instantanée d'intensité de courant délivrée par le processeur de traitement 83. Cette transmission vers l'extérieur se fait par l'intermédiaire d'une diode électroluminescente 86 et d'une fibre optique 87 monomode ou multimode constituant la sortie de l'appareil de mesure.

Le circuit d'horloge 85 reçoit un signal de synchronisation externe par l'intermédiaire d'une fibre optique 88. Il assure les synchronismes des fonctionnements du processeur de traitement 83 et du processeur de communication 84 ainsi que celui des prises d'échantillons par les convertisseurs analogiques-numériques 78, 82 sur le signal de synchronisation externe ce qui permet l'utilisation en parallèle de plusieurs appareils de mesure dans le cadre d'une application à un réseau électrique polyphasé où il importe que les mesures instantanées d'intensité soient simultanées sur toutes les phases. Il délivre aussi un signal d'horloge stable utilisé par le générateur synthétiseur de fréquence 71 de la partie émission pour élaborer les porteuses de modulation f1, f2, ainsi que la porteuse de démodulation f1-f2 convenablement déphasée pour un fonctionnement correct du circuit de démodulation synchrone 74.

Pour extraire explicitement la valeur instantanée du courant alternatif à mesurer à partir du signal s(t), le processeur de traitement 83 effectue le calcul :

$$\frac{1}{k1} \ \ \text{Arc sin} \ \ \frac{s(t)}{k2}$$

au moyen d'une table de définition de la fonction arc sinus, des valeurs des facteurs k1, k2 et d'un algorithme approprié.

La valeur du facteur d'efficacité de l'effet Faraday K1 pour le courant à mesurer dépend, comme on l'a vu précédemment, de paramètres fondamentaux V constante de Verdet, N nombre de tours effectués par les ondes lumineuses autour d'un conducteur parcouru par le courant à mesurer, qui sont peu susceptibles de varier. Elle est établie par une calibration initiale de la chaîne de mesure.

La valeur du facteur d'échelle k2 est sensible aux dérives des divers éléments de la chaîne de mesure et, notamment, aux variations de la puissance lumineuse émise par la source 55. Elle est affectée d'une erreur de dérive de zéro $\epsilon o$ et une erreur de dérive de rapport $\epsilon 1$ qui font que la valeur exacte de l'intensité instantanée du courant à mesurer est en fait :

$$\frac{1}{k1} \ \ \text{Arc sin} \ \ \frac{s(t) - \epsilon o)}{k2 - \epsilon 1}$$

L'erreur $\epsilon o$ de dérive du zéro peut être assimilée à la composante continue du signal s(t) de la partie de réception dans la mesure où le courant alternatif n'a pas de composante continue. Elle est alors déterminée par le processeur de traitement 83, par filtrage numérique du signal s(t) sur une courte durée où le courant alternatif à mesurer est jugé exempt de composante continue par exemple, pour un réducteur de courant haute tension lorsqu'il est inférieur à 1,2 In, et mise à jour avec une périodicité faible par rapport à la fréquence du courant alternatif à mesurer. Dans l'exemple précité elle est déterminée par filtrage numérique du signal s(t) sur une durée de l'ordre de 1 à 2 s avec une fréqence de récurrence de 0,001 Hz très faible par rapport à la fréquence de 50 au 60 Hz d'un réseau de courant alternatif.

Bien que cette méthode de détermination de l'erreur $\epsilon o$ de dérive du zéro permette de surveiller les composantes continues de défaut d'un courant alternatif à mesurer par une surveillance de l'amplitude de cette erreur $\epsilon o$, on lui préfère, dans le cas de l'appareil de mesure décrit et plus généralement de ceux qui utilisent une modulation des ondes lumineuses parcourant l'interféromètre, une autre méthode qui permet de s'affranchir d'une éventuelle composante continue. En effet, dans le cas de ces appareils de mesure, le signal de sortie est engendré à partir d'une raie à une fréquence supérieure à celle du courant alternatif à mesurer isolée dans le spectre de la puissance lumineuse du faisceaux issu de l'interféromètre et la suppression de cette raie par suppression de la modulation permet de faire apparaître en sortie une valeur résiduelle due uniquement aux dérives de zéro des éléments de la chaîne de mesure.

Selon cette autre méthode de détermination de l'erreur $\epsilon o$ de dérive du zéro, le processeur de traitement 83 arrête sur une courte durée la mesure de l'intensité instantanée du courant à mesurer et bloque le modulateur d'amplitude 70 ce qui a pour effet de faire disparaître le signal s(t) de la partie réception puisque celui-ci est proportionnel à l'indice m de la modulation d'amplitude (relation 4) et de faire apparaître une valeur résiduelle correspondant à l'erreur $\epsilon o$ de dérive de zéro des différents éléments de la chaîne de mesure. Pendant cette courte durée, le processeur de traitement 83 transmet au processeur de communication 84 des valeurs d'intensité instantanée mémorisées sur la période précédente du courant alternatif à mesurer. Cette interruption de courte durée de la mesure est tolérable car elle se reproduit avec une très faible récurrence par rapport à la période du courant alternatif à mesurer et uniquement lorsque l'on se trouve dans des conditions normales où l'absence d'une valeur élevée pour l'intensité détectée minimise les risques d'apparition d'un défaut en ligne.

L'élimination de l'erreur de rapport $\epsilon 1$ se fait grâce à un procédé de mise à jour périodique que le processeur de traitement 83 met en oeuvre simultanément avec le calcul de l'intensité instantanée du courant à mesurer en dehors des périodes où l'intensité moyenne du courant à mesurer est supérieure à une valeur jugée critique, par exemple 1,2 fois la valeur nominale, cette valeur critique étant choisie de manière que l'angle d'écart de phase k1I1 du à l'effet Faraday ne dépasse pas une dizaine de degrès.

Au cours de chaque mise à jour du facteur d'échelle k2, le processeur de traitement 83 détermine la valeur crête I1 du courant alternatif à mesurer puis provoque, par l'intermédiaire de la partie d'autocalibration, deux perturbations successive d'ampleurs différentes en injectant dans les bobines auxiliaires 44, 45 un courant continu de test prenant deux valeurs différentes d'intensité I21, I22, extrait les composantes continues so1 et so2 du signal de sortie s(t) de la partie réception apparaissant en réponse à ces deux perturbations et déduit la valeur de mise à jour k2- $\epsilon 1$ du facteur d'échelle à partir des valeurs de ces composantes continues so1, so2, de l'intensité de crête du courant à mesurer I1 calculée avec l'ancienne valeur k2 du facteur d'échelle et des deux intensités I21, I22 du courant continu de test.

Le processeur de traitement 83 détermine la valeur de crête I1 du courant alternatif à mesurer par exemple en effectuant une moyenne sur plusieurs périodes de ce courant, des maximum d'intensité détectés.

Les bobines auxiliaires 44 et 45 sont connectées en série de manière à engendrer dans la boucle de l'interféromètre des effets de biréfringence non réciproques additifs et ont un coefficient d'efficacité d'effet Faraday fonction de leurs nombres de spires. en dehors du procédé de mise à jour périodique du facteur d'échelle, elles ne sont parcourues par aucun courant, le processeur de traitement 83 bloquant le générateur de courant continu 80 de la partie d'autocalibration en lui appliquant une consigne d'intensité de courant continu de test nulle.

Au cours de la première perturbation d'un cycle de mise à jour du facteur d'échelle, qui se déroule pendant un temps T1 suffisant pour permettre le filtrage numérique de la composante so1 du signal s(t) de la partie réception, le processeur de traitement 83 applique au générateur de courant 80 de la partie d'autocalibration une consigne de courant imposant dans les bobines auxiliaires 44, 45 la circulation d'un courant continu d'intensité I21 comme représenté à la figure 4. Ce dernier engendre par effet Faraday un écart de phase $\Delta'\phi$ entre les deux ondes contrapropagatives parcourant la boucle de l'interféromètre qui s'ajoutent avec celui $\Delta\phi$ dû au courant alternatif à mesurer pour donner un écart de phase total égal à :

$$\Delta\phi \ + \ \Delta'\phi \ = \ k1 \ I1 \ \sin wt \ + \ k3 \ I21$$

Il provoque, en sortie de la partie réception c'est-à-dire du convertisseur analogique-numérique 78 un signal s(t) de la forme :

$$s(t) \ = \ \epsilon o \ + \ (k2 - \epsilon 1) \sin [k1 \ I1 \ \sin wt \ + \ k3 \ I21]$$

dont la composante continue s'exprime par :

$$so1 \ = \ \epsilon o \ + \ (k2 - \epsilon 1) \ Jo \ (k1 \ I1) \sin (k3 \ I21)$$

Jo étant la fonction de Bessel de première espèce d'ordre zéro.

Au cours de la deuxième pertubation d'un cycle de mise à jour du facteur d'échelle, qui se déroule pendant un temps T2 également suffisant pour permettre le filtrage numérique de la composante continue so2 du signal s(t) de la partie réception, le processeur de traitement 83 applique au générateur de courant 80 de la partie d'autocalibration une autre consigne de courant imposant dans les bobinages auxiliaires 44, 45 la circulation d'un courant continu d'intensité I22 qui, comme le montre la figure 4, est de sens opposé à celui I21 de la première perturbation et de valeur différente, l'égalité étant difficile à réaliser avec précision et, par ailleurs non nécessaire. Ce courant continu d'intensité I22 provoque, de la même façon que le courant continu d'intensité I21, l'apparition d'une composante continue so2 en sortie du convertisseur analogique-numérique de la partie réception qui s'exprime par :

so2 = $\epsilon$o + (k2 - $\epsilon$1) Jo (k1 I1) sin (k4 I22)

La différence des deux composantes continues so1 et so2 n'est pas sensible à l'erreur $\epsilon$o de dérive du zéro et est liée à la valeur exacte du facteur d'échelle par la relation :

$$k2 - \mathcal{E}1 = \frac{so1 - so2}{\mathrm{J} \, o \, (k1.I1) \, \left[ \sin k3 \, I21 - \sin k4 \, I22 \right]}$$

Le processeur de traitement effectue ce calcul à l'aide d'un algorithme approprié.

On remarque que la précision de détermination de la grandeur k1 I1 n'intervient que peu dans la mesure où sa valeur ne dépasse pas la dizaine de degrès car, dans ce domaine de variation, la fonction de Bessel de première espèce d'ordre zéro a une faible pente de variation. Il n'en est pas de même de la précision de détermination des intensités de courant continu de test I21 et I22 c'est pourquoi le processeur de traitement 83 n'utilise pas les valeurs de consigne qu'il a émises mais des valeurs mesurées qui lui sont délivrées par le convertisseur analogique-numérique.

Le procédé auto-calibration que l'on vient de décrire est particulièrement intéressant dans le cas d'un réducteur de mesure constitué de deux appareils de mesure d'intensité à structure et fonctionnement identiques mais avec des sensibilités différentes, c'est-à-dire avec des nombres de spires de fibre optique au niveau du potentiel différents. Car dans ce cas, il sera possible de transmettre les mesures d'intensité instantanée issues de l'un des appareils sur la sortie de l'autre pendant le temps nécessaire au calage de son zéro et inversement.

## Revendications

1. Procédé de mise à jour du facteur d'échelle k2 d'un appareil de mesure d'intensité d'un courant électrique alternatif I1 sin wt par effet Faraday mis en oeuvre au sein d'un interféromètre délivrant en sortie un faisceau lumineux ayant une puissance optique avec une composante de son spectre de fréquence qui est proportionnelle, dans le rapport dudit facteur d'échelle k2, au sinus ou au cosinus de l'écart de phase engendré par l'effet Faraday sur les ondes lumineuses parcourant l'interféromètre, ledit écart de phase étant lui-même proportionnel dans le rapport d'un facteur k1 dit d'efficacité d'effet Faraday à l'intensité instantanée du courant à mesurer, et qui est extraite par un photodétecteur (76) et une électronique associée pour constituer un signal de sortie s(t) = k2 sin(k1 I1 sin wt) de l'interféromètre, le dit procédé étant caractérisé en ce qu'il consiste à :
   - déterminer l'intensité de crête I1 du courant alternatif à mesurer à partir du signal s(t) de sortie de l'interféromètre, de la valeur k1 du coefficient d'efficacité de l'effet Faraday pour le courant alternatif à mesurer et de la valeur k2 disponible du facteur d'échelle,
   - provoquer deux perturbations successives d'amplitudes différentes par ajout à l'effet Faraday dû au courant alternatif à mesurer d'un effet Faraday auxiliaire engendré par un courant continu de test prenant successivement deux valeurs distinctes d'intensité I21 et I22 différentes de zéro avec des facteurs d'efficacité d'effet Faraday k3, k4;
   - mémoriser les composantes continues so1 et so2 du signal de sortie s(t) de l'interféromètre en réponse aux deux perturbations précédentes et
   - adopter comme nouvelle valeur du facteur d'échelle k2 celle de l'expression :

$$\frac{so1 - so2}{\mathrm{J} \, o \, (k1.I1) \, \left[ \sin k3 \, I21 - \sin k4 \, I22 \right]}$$

Jo étant la fonction de Bessel de première espèce d'ordre zéro.

2. Procédé selon la revendication 1 caractérisé en ce que les dites perturbations successives sont engendrées par ajout à l'effet Faraday du au courant alternatif à mesurer, d'un effet Faraday auxiliaire provoqué par un courant continu de test prenant successivement deux valeurs d'intensité distinctes I21

EP 0 289 791 B1

et I22 et parcourant au moins un enroulement électrique auxiliaire (44, 45) qui modifie le champ magnétique agissant sur la boucle de l'interféromètre et qui est électriquement isolé du conducteur (11) parcouru par le courant alternatif à mesurer.

3.  Procédé selon la revendication 1 appliqué à un appareil de mesure d'intensité à interféromètre équipé de modulateurs d'ondes lumineuses donnant à la dite composante une fréquence supérieure à celle du courant alternatif à mesurer caractérisé en ce qu'il consiste en outre à bloquer périodiquement le dit modulateur pour supprimer ladite composante et faire apparaître dans le signal de sortie de l'interféromètre s(t) une valeur résiduelle correspondant à l'erreur $\epsilon$o de dérive de zéro de ce signal de sortie dont il est tenu compte pour le corriger avant chacune de ses utilisations.

4.  Procédé selon la revendication 1 appliqué à un appareil de mesure d'intensité à interféromètre équipé d'un modulateur d'amplitude (70) opérant sur la puissance lumineuse de la source (55) délivrant les faisceaux lumineux à l'origine des ondes le parcourant et donnant à la dite composante une fréquence supérieure à celle du courant alternatif à mesurer caractérisé en ce qu'il consiste en outre à bloquer périodiquement le dit modulateur d'amplitude (70) pour supprimer la dite composante et faire apparaître dans le signal de sortie de l'interféromètre s(t) une valeur résiduelle corespondant à l'erreur $\epsilon$o de dérive de zéro de ce signal de sortie dont il est tenu compte pour le corriger avant chacune de ses utilisations.

**Claims**

1.  A method of updating the scale factor k2 of a current measuring apparatus for measuring an alternating electrical current I1.sin$\omega$t by means of the Faraday effect implemented in an interferometer which delivers an output light beam whose optical power includes a frequency spectrum component which is proportional, to within said scale factor k2, to the sine or the cosine of the phase difference generated by the Faraday effect on the light waves travelling through the interferometer, said phase difference itself being proportional to the instantaneous intensity of the current to be measured as multiplied by a factor k1 referred to as Faraday effect efficiency factor, and which is extracted by a photodetector (76) and associated electronics in order to constitute an output signal s(t) = k2 sin(k1.I1.sin $\omega$t) from the interferometer, said method being characterized in that it consists in:
    - determining the peak value I1 of the alternating current to be measured from the output signal s(t) of the interferometer, from the value k1 of the Faraday effect efficiency factor for the alternating current to be measured, and from the available value k2 of the scale factor;
    - causing two successive disturbances of different amplitudes by adding an auxiliary Faraday effect to the Faraday effect due to the alternating current to be measured, said auxiliary effect being generated by a test direct current which successively takes on two distinct values I21 and I22 different from zero and perform at Faraday effect efficiency factors k3, k4;
    - storing the direct components so1 and so2 of the output signal s(t) from the interferometer in response to the above two disturbances; and
    - adopting a new scale factor k2 given by the expression

$$\frac{so1 - so2}{Jo(k1.I1) [\sin k3\ I21 - \sin k4\ I22]}$$

    where Jo is the zero order Bessel function of the first kind.

2.  A method according to claim 1, characterized in that said successive disturbances are generated by adding an auxiliary Faraday effect to the Faraday effect due to the alternating current to be measured, said auxiliary effect being caused by a test D.C. current which successively takes on two distinct current values I21 and I22 passing through at least one auxiliary electric coil (44, 45) which modifies the magnetic field acting on the interferometer loop and which is electrically isolated from the conductor (11) conveying the alternating current to be measured.

3.  A method according to claim 1, applied to an interferometer current measuring apparatus fitted with light wave modulators giving a frequency to said component which is higher than the frequency of the

11

alternating current to be measured, characterized in that it consists, in addition, in periodically blocking said modulator in order to suppress said component and cause a residual value to appear in the output signal s(t) from the interferometer, said residual value corresponding to the zero drift error $\epsilon 0$ in said output signal, with account being taken thereof for correction purposes prior to making use thereof.

4. A method according to claim 1, applied to an interferometer current measuring apparatus equipped with an amplitude modulator (70) operating on the light power emitted by the source (55) which delivers the light beam giving rise to the waves travelling through the interferometer, and giving a frequency to said component which is higher than the frequency of the alternating current to be measured, characterized in that it consists, in addition, in periodically blocking said amplitude modulator (70) in order to suppress said component and cause a residual value to appear in the output signal s(t) from the interferometer, said residual value corresponding to the zero drift error $\epsilon 0$ in said output signal, with account being taken thereof for correction purposes prior to making use thereof.

**Patentansprüche**

1. Verfahren zur Aktualisierung des Skalenfaktors k2 eines Geräts zur Messung der Stärke eines elektrischen Wechselstroms I1 sin$\omega$t mit Hilfe des Faradayeffekts in einem Interferometer, das einen Lichtstrahl am Ausgang liefert, dessen optische Leistung eine Komponente des Frequenzspektrums aufweist, die im Verhältniswert des Skalenfaktors k2 dem Sinus oder Cosinus der Phasenabweichung proportional ist, welche der Faradayeffekt an den das Interferometer durchlaufenden Lichtwellen bewirkt, wobei die Phasenabweichung bis auf einen Faktor k1, Wirkungsgrad des Faradayeffekts genannt, der Momentanstärke des zu messenden Stroms proportional ist, und wobei die Komponente durch einen Photodetektor (76) und eine zugehörige Elektronik zur Bildung eines Ausgangssignals s(t) = k2.sin(k1.I1.sin$\omega$t) des Interferometers entnommen wird, dadurch gekennzeichnet, daß das Verfahren darin besteht:

   - den Spitzenwert I1 der zu messenden Stromstärke aus dem Ausgangssignal s(t) des Interferometers, dem Wert k1 des Wirkungsgrads des Faradayeffekts für den zu messenden Wechselstrom und dem verfügbaren Wert k2 des Skalenfaktors zu bestimmen;
   - zwei aufeinanderfolgende Störungen unterschiedlicher Amplitude durch Hinzufügen eines Hilfs-Faradayeffekts zu dem auf den zu messenden Wechselstrom zurückzuführenden Faradayeffekt zu verursachen, wobei der Hilfs-Faradayeffekt durch einen Prüfgleichstrom erzeugt wird, der nacheinander zwei bestimmte, von Null unterschiedliche Stromstärkewerte I21 und I22 mit Wirkungsgradfaktoren k3, k4 des Faradayeffekts annimmt,
   - die Gleichkomponenten so1 und so2 des Ausgangssignals s(t) des Interferometers als Antwort auf die beiden vorhergehenden Störungen zu speichern, und
   - als neuen Wert des Skalenfaktors k2 den dem Ausdruck

$$\frac{so1 \ - \ so2}{Jo(k1.I1) \ [sin \ k3 \ I21 \ - \ sin \ k4 \ I22]}$$

   entsprechenden Wert anzunehmen, wobei Jo die Besselfunktion erster Art nullter Ordnung darstellt.

2. Verfahren nach Anspruch 1, dadurch gekennzeichnet, daß die aufeinanderfolgenden Störungen durch Hinzufügen eines Hilfs-Faradayeffekts zu dem auf den zu messenden Wechselstrom zurückzuführenden Faradayeffekt verursacht werden, wobei der Hilfs-Faradayeffekt durch einen Prüfgleichstrom erzeugt wird, der nacheinander zwei unterschiedliche Stromstärkewerte I21 und I22 annimmt und mindestens eine elektrische Hilfswicklung (44, 45) durchfließt, die das auf die Schleife des Interferometers einwirkende magnetische Feld verändert und elektrisch von dem vom zu messenden Strom durchflossenen Leiter (11) isoliert ist.

3. Verfahren nach Anspruch 1, angewandt auf ein Gerät zur Messung der Stromstärke in einem mit Lichtwellenmodulatoren ausgestatteten Interferometer, die der genannten Komponente eine Frequenz erteilen, welche höher als diejenige des zu messenden Wechselstroms ist, dadurch gekennzeichnet, daß das Verfahren weiter darin besteht, den Modulator periodisch zu sperren, um die Komponente zu unterdrücken und im Ausgangssignal s(t) des Interferometers einen Restwert erscheinen zu lassen, der

dem Nulldriftfehler $\epsilon_0$ des Ausgangssignals entspricht, welchem zur Korrektur des Signals vor jeder Anwendung Rechnung getragen wird.

4. Verfahren nach Anspruch 1, dadurch gekennzeichnet, angewandt auf ein Gerät zur Messung der Stromstärke mit einem Interferometer mit Amplitudenmodulator (70), der auf die Lichtstärke der Quelle (55) einwirkt, welche die Lichtstrahlen liefert, die die den Modulator durchlaufenden Wellen verursachen, und der der genannten Komponente eine Frequenz erteilt, die höher ist als diejenige des zu messenden Wechselstroms, dadurch gekennzeichnet, daß das Verfahren weiter darin besteht, periodisch den Amplitudenmodulator (70) zu sperren, um die Komponente zu unterdrücken und im Ausgangssignal s(t) des Interferometers einen Restwert erscheinen zu lassen, der dem Nulldriftfehler $\epsilon_0$ dieses Ausgangssignals entspricht, welchem zur Korrektur des Signals vor jeder Anwendung Rechnung getragen wird.

FIG.1

FIG.2

# FIG.3

EP 0 289 791 B1

# FIG.4